# EUROPEAN PATENT SPECIFICATION

(11) **EP 2 641 404 B1**
(45) Date of publication and mention of the grant of the patent: **19.07.2017**
(21) Application number: 11788214.2
(22) Date of filing: 18.11.2011
(51) Int. Cl.: H04Q 1/10, H05K 7/18

(54) **ENCLOSURE**
GEHÄUSE
ENCEINTE

(30) Priority: 19.11.2010 GB 201019629
(43) Date of publication of application: 25.09.2013
(73) Proprietor: Cooper B-Line Limited, Highbridge, Somerset TA9 4AQ (GB)
(72) Inventor: WRIGHT, Colin Morgan, Somerset TA8 2DQ (GB)
(74) Representative: Abel & Imray
(86) International application number: PCT/GB2011/052270
(87) International publication number: WO 2012/066353

(56) References cited:
- US-A- 6 036 290
- US-A1- 2003 062 326

## Description

### Technical Field

This invention relates generally to enclosures and, in particular, to enclosures suitable for use in a telecommunications or a data communications network and to methods of assembling enclosures. Such enclosures are commonly used to house a variety of electronic and cable connecting equipment.

### Background of the Invention

Enclosures are commonly provided to house a variety of computer, telecommunications and other data equipment to which a multiplicity of cables are connected. Examples of enclosures having seismic subframes are described in US 6036290 where in Fig. 9 an enclosure is shown that comprises an upper frame assembly that extends across an upper region of the enclosure, a lower frame assembly that extends across a lower region of the enclosure, first, second, third and fourth upright frame members connectible between the upper frame assembly and the lower frame assembly, and upright subframe assemblies able to be moved independently of the upright frame members. The enclosure is assembled with the first and second upright frame members disposed at the front of the enclosure at opposite sides thereof and the third and fourth upright frame members disposed at the rear of the enclosure at opposite sides thereof with the subframe assemblies positioned between the front and rear of the enclosure.

Whilst it is desirable to enclose the equipment to protect it and also to protect persons from contact with it, it is also desirable to be able to gain as much access as possible to the equipment in the enclosure.

In WO 99/48305 this problem is addressed and an enclosure is described which has a novel skeleton frame structure including a pair of upright frame members at the centres of the sides of the enclosure and top and bottom rectangular frame assemblies secured to opposite ends of the frame members. That arrangement contrasts with a more standard arrangement in which four upright frame members are provided in the regions of the corners of an enclosure and provides certain advantages over the more standard arrangement. Upright mounting angles are provided in addition to the frame members.

Enclosures are used in a wide variety of applications and different forms of enclosure suit different applications. Thus an enclosure of the kind described in WO 99/48305 may be of benefit in one application because, for example, the placing of the upright frame members away from the front and back of the enclosure makes access to the front and back easier, whilst the more standard arrangement with upright frame members in the corner regions of the enclosure may be of benefit in another application because, for example, particular strength is required at the front or back of the frame.

It is an object of the invention to provide an improved enclosure and an improved method of assembling an enclosure.

### Summary of the Invention

According to the invention there is provided an enclosure suitable for use in a telecommunications or data communications network, the enclosure being of generally cuboidal shape, including an upper frame assembly that extends across an upper region of the enclosure, a lower frame assembly that extends across a lower region of the enclosure, first, second, third and fourth upright frame members connectible between the upper frame assembly and the lower frame assembly, and upright mounting angles suitable for mounting equipment for use in a telecommunications or data communications network, the positions of the upright mounting angles being able to be moved independently of the upright frame members, the enclosure being able to be assembled in a first configuration in which the first and second upright frame members are disposed at the front of the enclosure at opposite sides thereof and the third and fourth upright frame members are disposed at the rear of the enclosure at opposite sides thereof, characterised in that the first, second, third and fourth upright frame members are connectible between the upper frame assembly and the lower frame assembly in a plurality of different positions in the regions of the sides of the enclosure to provide different configurations of the enclosure and the enclosure is also able to be assembled in a second configuration in which the first, second, third and fourth upright frame members are disposed in regions spaced from the front and rear regions of the enclosure.

By providing an enclosure that can be assembled with upright frame members in different positions, a user is able to select a particular frame configuration most suitable for a particular application. For example, the first configuration might be chosen for maximum strength of the frame, whilst the second configuration might be chosen to enhance access to the front and rear of the frame. The frame may be a skeleton frame. The upright frame members preferably provide at least the major structural connection between the upper and lower frame assemblies.

It should be noted that according to the invention it is the upright frame members themselves that are able to be assembled in different positions. The upright mounting angles are also be able to be moved independently of the upright frame members. Preferably the upright mounting angles are able to be moved forwardly and rearwardly in the frame and more preferably are continuously adjustable to any position within their range of movement.

Preferably all of the upright frame members are able to be assembled in different positions. This enables the frame to be provided with good versatility.

In one form of the second configuration of the enclosure, the first and third frame members may be adjacent to one another; similarly, the second and fourth frame members may be adjacent to one another; in this case the frame members may be alongside one another and in contact with one another or virtually in contact with one another. Another possible form of the second configuration is one in which there is an elongate vertical gap between the first and third frame members and another elongate vertical gap between the second and fourth frame members. Preferably each gap, if there is one, is a narrow gap, the width of each gap extending along a respective side of the enclosure. The enclosure may be able to be assembled in either or both forms of the second configuration.

Preferably, in the second configuration of the enclosure, the first, second, third and fourth frame members are disposed approximately midway between the front and rear of the enclosure. More preferably the first and third members are symmetrically disposed on opposite sides of a vertical plane midway between the front and rear of the enclosure.

The enclosure is preferably able to be assembled in a third configuration in which the first and second upright frame members are disposed at the front of the enclosure and the third and fourth upright frame members are disposed in a region spaced from the front and rear regions of the enclosure. In the third configuration of the enclosure, the third and fourth upright frame members are preferably disposed approximately midway between the front and rear of the enclosure. In the third configuration of the enclosure access to the rear of the enclosure can be facilitated. Similarly, the enclosure is preferably able to be assembled in a fourth configuration in which the third and fourth upright frame members are disposed at the rear of the enclosure and the first and second upright frame members are disposed in a region spaced from the front and rear regions of the enclosure. In the fourth configuration of the enclosure, the first and second upright frame members are preferably disposed approximately midway between the front and rear of the enclosure. In the fourth configuration of the enclosure access to the front of the enclosure can be facilitated. It should be understood that in the third and fourth configurations, the positions of the first and second upright members on the one hand, and the positions of the third and fourth upright members on the other hand, can be interchanged.

The enclosure is preferably able to be assembled in a fifth configuration in which the first and second upright frame members are disposed at opposite sides of the enclosure and the third and fourth upright frame members are disposed at opposite sides of the enclosure, with the first and third frame members on one side of the enclosure and the second and fourth frame members on the opposite side of the enclosure, and with the spacing of the first and third frame members different from the spacing of the second and fourth frame members. In the fifth configuration, the first frame member is preferably disposed at the front of the enclosure, the third frame member is preferably disposed at the rear of the enclosure, and the second and fourth frame members are preferably disposed in regions spaced from the front and rear regions of the enclosure. In the fifth configuration of the enclosure, the second and fourth upright frame members are preferably disposed approximately midway between the front and rear of the enclosure. A configuration of this kind may for example be employed together with another enclosure placed alongside in a configuration that is a mirror image of the first. In that case the two enclosures together may define a double width enclosure with upright frame members at each of its four corners but with no vertically extending obstruction in the middle of the front and back of the enclosure; if desired one or more further enclosures may be fitted between said two enclosures, with those one or more enclosures being in the second configuration.

Some or all of the upright frame members may be of the same construction, allowing them to be interchanged.

The enclosure may further include fifth and sixth upright frame members, and the enclosure may be able to be assembled in the first configuration with the fifth and sixth upright frame members disposed in regions spaced from the front and rear regions of the enclosure. In this configuration of the enclosure, the fifth and sixth upright frame members are preferably disposed approximately midway between the front and rear of the enclosure.

It should be understood that where reference is made, for example, to the fourth or fifth configurations that should not be taken as implying that all the other configurations of lower number are necessarily possible; for example, it is within the scope of the invention for the enclosure to be able to be assembled in the fourth configuration but not the third, or to be able to be assembled in the fifth and sixth configurations but not the third and fourth.

In an enclosure for use in a telecommunications or data communications network it is conventional to provide vertically extending mounting angles for mounting electrical equipment such as cable connecting equipment and computer equipment such as modems and servers. The mounting angles may be designed according to any required standard; for example, they may be IEC 297-1 mounting angles or ETSI 300-119 Part 3 mounting angles or mounting angles according to another telecommunications standard. The mounting angles are preferably secured to the upper and lower frame assemblies. Whilst the mounting angles may contribute to a modest extent to the structural strength of the frame, it is preferable that the strength is provided principally by the upright frame members. The mounting angles are preferably able to be removed without destroying the structural integrity of the frame.

The mounting angles are preferably secured to the frame in a manner that enables their position to be adjusted continuously between extreme forward and rearward positions.

The upper and lower frame assemblies preferably include frame parts extending substantially horizontally along the sides of the frame. Each frame assembly may be of generally rectangular shape. Preferably each frame assembly is of generally rectangular shape. The assemblies may comprise frame parts around the peripheries of the assemblies only. In embodiments of the invention described below, each frame assembly comprises a pair of horizontal frame members along the sides of the assembly and a pair of horizontal frame members along the front and back of the assembly. The horizontal frame members may be connected together at their corners, for example by bolts.

Preferably the upright frame members are connectible, for example by bolts, to the frame parts at a multiplicity of discrete positions along the frame parts. Another possibility is for the upright frame members to be connectible at any point along the frame parts to allow continuous adjustment of their positions.

In an embodiment of the invention described below, the frame parts have channels extending along their lengths for receiving ends of the upright frame members.

Whilst the product of the invention is described as an enclosure, it should be understood that it is not essential for the interior to be enclosed on all sides. One or more sides may be partly or fully open. It is preferred, however, that the enclosure further includes one or more panels providing a cover for at least a part of a face of the enclosure. The panels are preferably mounted on the upper and lower frame assemblies. That facilitates the provision of an enclosure that can be assembled readily in the first or second, or other, configurations. The panels preferably include one or more side panels covering over at least a part of the side of the enclosure. Panels may be provided over all six faces of the enclosure. The panels may include door panels.

According to the invention there is provided a method of assembling an enclosure for use in a telecommunications or data communications network, the method including the steps of providing an enclosure as defined above, connecting the first, second, third and fourth upright frame members in upright positions extending between the upper and lower frame assemblies extending across upper and lower regions of the enclosure respectively, wherein the positions at which the upright frame members are connected to the upper and lower frame assemblies is chosen to provide a selected one of a plurality of desired configurations of enclosure, the desired configurations including the first configuration in which the first and second upright frame members are disposed at the front of the enclosure at opposite sides thereof and the third and fourth upright frame members are disposed at the rear of the enclosure at opposite sides thereof, and the second configuration in which the first, second, third and fourth upright frame members are disposed in regions spaced from the front and rear regions of the enclosure.

The enclosure may initially be assembled in a chosen configuration and may always be used in that configuration, but it is also possible to change the configuration of the enclosure during its life. Thus, the method may further include the steps of assembling the enclosure in a chosen one of the plurality of configurations, subsequently dissembling the enclosure and reassembling the enclosure in another chosen one of the plurality of configurations.

The enclosure assembled by the method of the invention may take any of the forms defined above.

It will be appreciated that the enclosure of the invention and the assembly method of the invention as described herein are closely related and that therefore essential or preferred features of one may, unless indicated otherwise or clearly inappropriate, be incorporated into the other. Thus, features described above in respect of the enclosure of the invention may be incorporated into the assembly method of the invention and *vice versa.*

### Brief Description of the Drawings

By way of example embodiments of the invention will now be described with reference to the accompanying schematic drawings, of which:
- Fig. 1A: is an isometric view of an enclosure frame with frame members in a first configuration and mounting angles in one configuration;
- Fig. 1B: is an isometric view of the enclosure frame of Fig. 1A with frame members in the first configuration and mounting angles in another configuration;
- Fig. 2A: is an isometric view of the enclosure frame of Fig. 1A with frame members in a second configuration and mounting angles in one configuration;
- Fig. 2B: is an isometric view of the enclosure frame of Fig. 2A with frame members in the second configuration and mounting angles in another configuration;
- Fig. 3A: is an isometric view of the enclosure frame of Fig. 1A with frame members in a third configuration and mounting angles in one configuration;
- Fig. 3B: is an isometric view of the enclosure frame of Fig. 3A with frame members in the third configuration and mounting angles in another configuration;
- Fig. 4A: is an isometric view of the enclosure frame of Fig. 1A with the frame members in a fourth configuration and mounting angles in one configuration;
- Fig. 4B: is an isometric view of the enclosure frame of Fig. 4A with frame members in the fourth configuration and mounting angles in another configuration;
- Fig. 5A: is an isometric view of the enclosure frame of Fig. 1A with the frame members and mounting angles in the same configuration as in Fig. 1A, but with two additional upright frame members;
- Fig. 5B: is an isometric view of the enclosure frame of Fig. 5A with the members in the same configuration as in Fig. 5A, but with the mounting angles in the same configuration as in Fig. 1B;
- Fig. 6A: is an isometric view of the enclosure frame as shown in Fig. 1B, showing in an exploded view side panels for fitting to the frame;
- Fig. 6B: is an isometric view of the enclosure frame as shown in Fig. 2A, showing in an exploded view side panels for fitting to the frame;
- Fig. 6C: is an isometric view of the enclosure frame as shown in Fig. 3A, showing in an exploded view side panels for fitting to the frame;
- Fig. 7A: is an isometric view showing a first form of fastening system for fastening mounting angles to the frame; and
- Fig. 7B: is an isometric view similar to Fig. 7A but showing a second form of fastening system for fastening mounting angles to the frame.

### Detailed Description of Embodiments

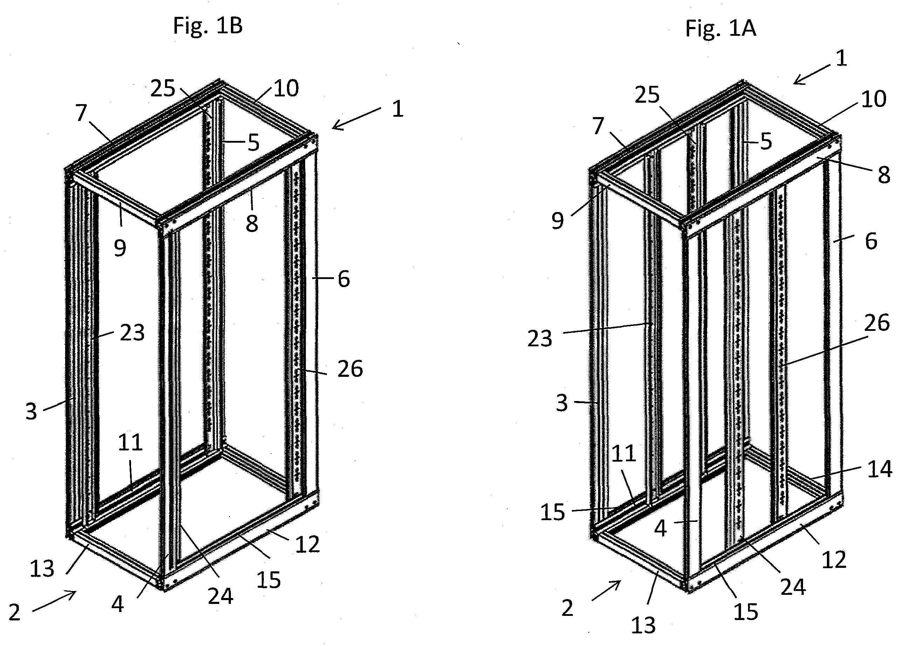

Referring first to Fig. 1A, there is shown an enclosure frame generally comprising an upper frame assembly 1, a lower frame assembly 2, and four upright frame members 3, 4, 5 and 6 each connected between the upper and lower frame assemblies 1, 2. The upper frame assembly 1 is rectangular and comprises a pair of horizontal side frame members 7 and 8, a front horizontal frame member 9 and a rear horizontal frame member 10. Similarly, the lower frame assembly 2 is rectangular and comprises a pair of horizontal side frame members 11 and 12, a front horizontal frame member 13 and a rear horizontal frame member 14. Each of the side frame members 7, 8 is formed with a channel 15 in its bottom face, extending along the whole length of the member. Similarly, each of the side frame members 11, 12 is formed with a channel 15 in its top face, extending along the whole length of the member. In Fig. 1A the channels in the side frame members 11, 12 are visible, but not the channels in the frame members 7, 8.

In a first configuration of the frame, shown in Fig. 1A, the first upright frame member 3 and the second upright frame member 4 are at the front of the frame, with their top ends received in the front ends of the channels 15 in the horizontal side frame members 7 and 8 and their bottom ends received in the front ends of the channels 15 in the horizontal side frame members 11 and 12. Similarly the third upright frame member 5 and the fourth upright frame member 6 are at the rear of the frame, with their top ends received in the rear ends of the channels 15 in the horizontal side frame members 7 and 8 and their bottom ends received in the rear ends of the channels 15 in the horizontal side frame members 11 and 12.

Also shown in Fig. 1A are a first pair of mounting angles 23, 24 towards the front of the enclosure and a second pair of mounting angles 25, 26 towards the rear of the enclosure. The mounting angles 23 to 26 are secured to the inner sides of the horizontal side frame members 7, 8, 11 and 12. Such mounting angles are for mounting equipment for use in a telecommunications or data communications network. In an enclosure for use in a telecommunications or data communications network it is conventional to provide such vertically extending mounting angles for mounting electrical equipment (not shown) such as cable connecting equipment and computer equipment such as modems and servers. The mounting angles may be arranged according to any required standard; for example, they may be IEC 297-1 mounting angles or ETSI 300-119 Part 3 mounting angles or mounting angles according to another telecommunications standard. Whilst the mounting angles 23 to 26 will contribute to a modest extent to the structural strength of the frame when they are secured in place, the strength of the frame is provided principally by the upright frame members. The mounting angles can be removed without destroying the structural integrity of the frame.

The fasteners used to fasten the upright frame members 3, 4, 7, 8 to the side frame members 7, 8, 11 and 12 may be of any suitable kind. Similarly, the fasteners used to fasten the mounting angles 23 to 26 to the side frame members may be of any suitable kind. For example, the fasteners may simply comprise bolts, passing through holes in the frame members and mounting angles and nuts fastened tightly on the bolts. Alternatively, more sophisticated fastenings may be employed.

Fig. 1B shows the frame of Fig. 1A with the upright frame members 3, 4, 5 and 6 in the same position as in Fig. 1A, but with the mounting angles 23 to 26 in different positions. In Fig. 1B the first pair of mounting angles 23, 24 are at the front of the frame just behind the frame members 3 and 4, whilst the second pair of mounting angles 25, 26 are at the rear of the frame just in front of the frame members 5 and 6.

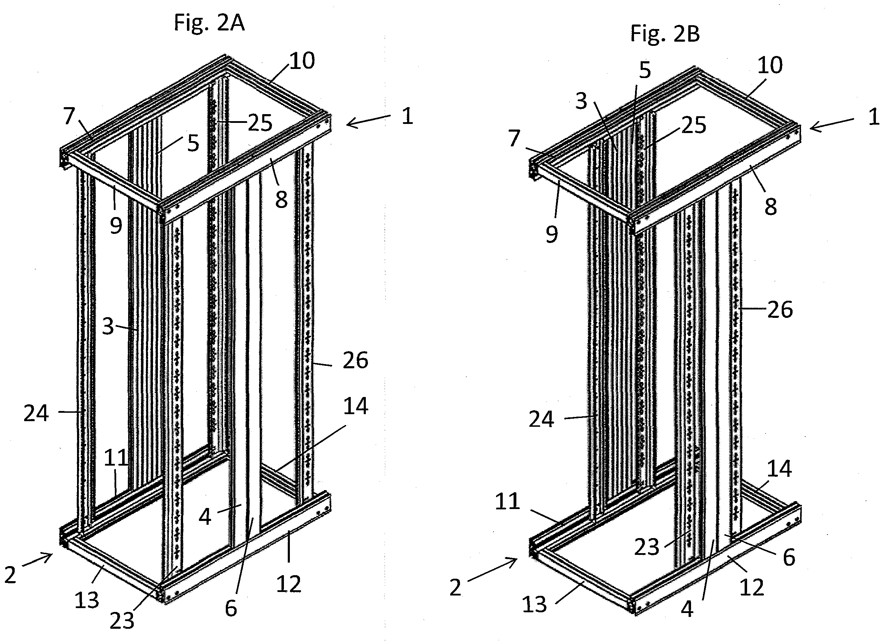

Fig. 2A shows a second configuration of the frame in which the upright frame members 3, 4, 5 and 6 are moved from the corners of the enclosure to the middle of the sides of the enclosure. In Fig. 2A, the upright frame member 3 and the upright frame member 5 are immediately adjacent to one another with no gap between them and, similarly, the upright frame member 4 and the upright frame member 6 are immediately adjacent to one another with no gap between them. The interface of the frame members 3 and 5 and the interface of the frame members 4 and 6 lie in a vertical plane equispaced from the front and rear of the enclosure frame.

In Fig. 2A, the first pair of mounting angles 23, 24 is provided at the front of the enclosure, and the second pair of mounting angles 25, 26 is provided at the rear of the enclosure.

Fig. 2B shows the frame of Fig. 2A with the upright frame members 3, 4, 5 and 6 in the same position as in Fig. 1A, but with the mounting angles 23 to 26 in different positions. In Fig. 2B, the first pair of mounting angles 23, 24 are moved rearwardly from their positions in Fig. 2A and are just in front of the frame members 3 and 4, whilst the second pair of mounting angles 25, 26 are moved forwardly from their positions in Fig. 2A and are just behind the frame members 5 and 6.

As will be understood, another possible arrangement of frame members, very similar to that of Fig. 2B, would be to provide a narrow gap between the upright frame members 3 and 5 and, similarly, a narrow gap between the upright frame members 4 and 6. The slight spacing apart of the frame members may increase the structural strength of the enclosure and also provides a central opening through which cables can be passed if desired.

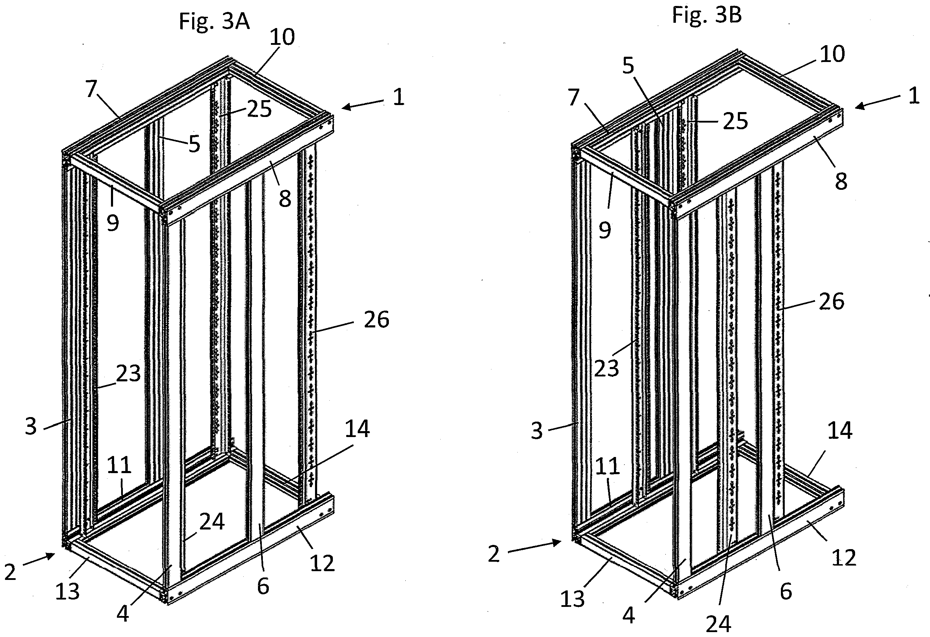

Fig. 3A shows an arrangement in which one pair of frame members are connected between the mid-points of the sides of the upper and lower frame assemblies 1 and 2, whilst the other pair of frame members are connected at the front or rear of the enclosure. In this third configuration of the enclosure shown in Fig. 3A, the upright frame members 3 and 4 are at the front of the enclosure and the upright frame members 5 and 6 are midway between the front and rear of the enclosure. Of course another, very similar, configuration is one in which the upright frame members 3 and 4 are midway between the front and rear of the enclosure and the upright frame members 5 and 6 are at the rear of the enclosure. That is referred to herein as a fourth configuration.

In Fig. 3A the first pair of mounting angles 23, 24 is provided at the front of the enclosure immediately behind the front frame members 3 and 4 and the second pair of mounting angles 25, 26 is provided at the rear of the enclosure.

Fig. 3B shows the frame of Fig. 3A with the upright frame members 3, 4, 5 and 6 in the same position as in Fig. 1A, but with the mounting angles 23 to 26 in different positions. In Fig. 3B, the first pair of mounting angles 23, 24 are moved rearwardly from their positions in Fig. 3A and are midway between the first pair of frame members 3 and 4 and the second pair of frame members 5 and 6, whilst the second pair of mounting angles 25, 26 are moved forwardly from the rear of the frame to positions just behind the second pair of frame members 5 and 6.

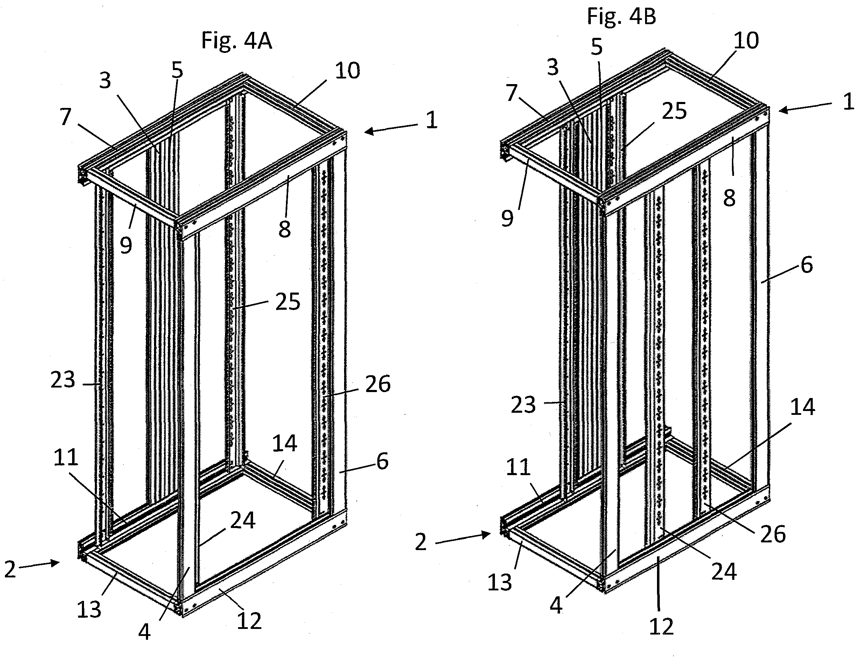

The configurations described with reference to Figs. 1A to 3B are all symmetrical about a central vertical plane equispaced from the two opposite sides of the enclosure. Fig. 4A shows a fourth configuration where there is no such symmetry. Whilst the upright frame member 4 is at the front of the enclosure and the upright frame member 6 at the rear of the enclosure on the same side as the upright frame member 4, the upright frame member 3 and the upright frame member 5 are arranged as in Fig. 2A on the opposite side of the enclosure midway between the front and rear of the enclosure.

In Fig. 4A, the first pair of mounting angles 23, 24 is provided at the front of the enclosure with the mounting angle 24 just behind the frame member 4, and the second pair of mounting angles 25, 26 is provided at the rear of the enclosure with the mounting angle 26 just in front of the frame member 6.

Fig. 4B shows the frame of Fig. 4A with the upright frame members 3, 4, 5 and 6 in the same position as is in Fig. 4A, but with the mounting angles 23 to 26 in different positions. In Fig. 4B the first pair of mounting angles 23, 24 are moved rearwardly from their positions in Fig. 4A such that the mounting angle 23 is just in front of the frame member 3 with the mounting angle 24 opposite the mounting angle 23, whilst the second pair of mounting angles 25, 26 are moved forwardly from their positions in Fig. 4A such that the mounting angle 25 is just behind the frame member 5 with the mounting angle 26 opposite the mounting angle 25.

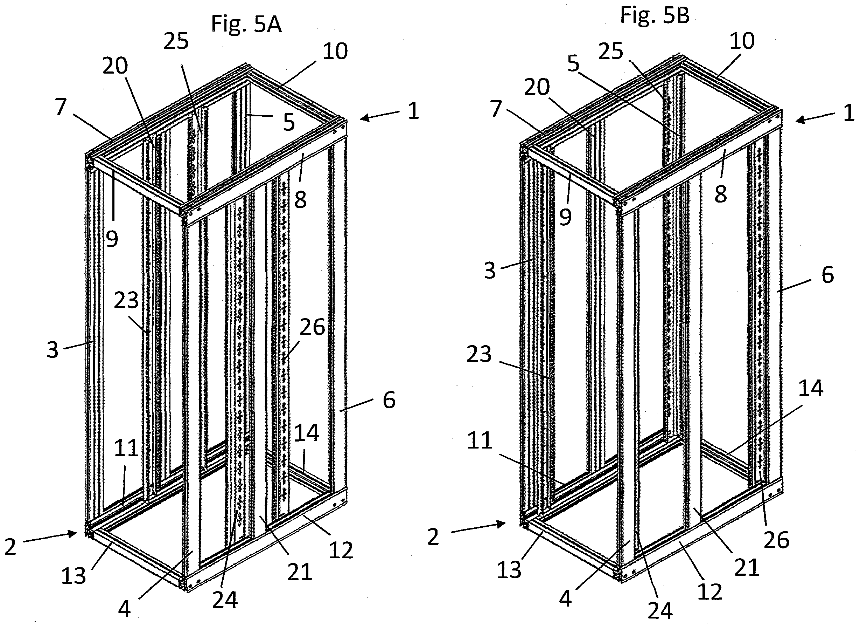

Fig. 5A shows the upright frame members 3, 4, 5 and 6 connected in the same position as in Fig. 1A, and the mounting angles 23 to 26 connected in the same positions as in Fig. 1A, but with two additional upright frame members 20 and 21 provided. The additional frame members 20 and 21 are positioned on opposite sides of the enclosure midway between the front and rear of the enclosure in Fig. 5A.

Fig. 5B shows the frame of Fig. 5A with the upright frame members 3, 4, 5, 6, 20 and 21 in the same position as in Fig. 5A, but with the mounting angles 23 to 26 in different positions. In Fig. 5B the mounting angles are in the position shown in Fig. 1B. Thus the first pair of mounting angles 23, 24 are at the front of the frame just behind the frame members 3 and 4, whilst the second pair of mounting angles 25, 26 are at the rear of the frame just in front of the frame members 5 and 6.

It will be understood that in the embodiments described the upright frame members 3, 4, 5, 6, 20 and 21 are all interchangeable. It should also be understood that whilst various configurations of frame members and mounting angles have been shown and described, many other configurations can also be adopted.

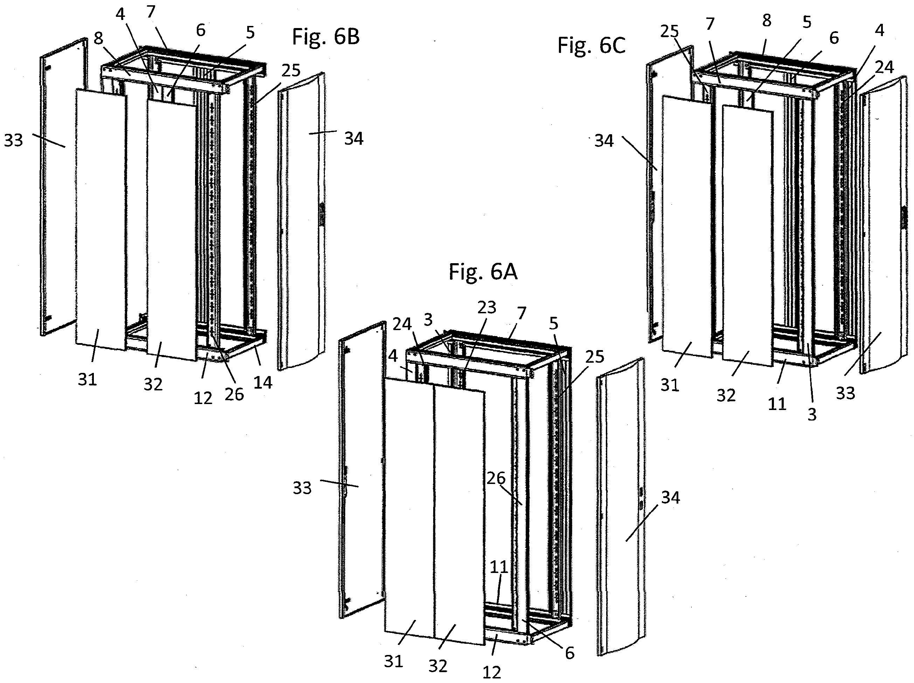

In the drawings only the skeleton frame of each configuration of enclosure is shown. It should be understood that panels, which may include hinged door panels, may be connected to the upper and lower frame assemblies 1, 2. WO 99/48305 describes such arrangements and also other features that may be incorporated in the enclosure of the present invention. Fig. 6A shows how side panels may be fitted to the frame when the upright frame members 3 to 6 are in the positions shown in Figs. 1A and 1B. In Fig. 6A the mounting angles 23 to 26 are shown in the positions shown in Fig. 1B, but of course it is also possible for them to be in other positions, including but not limited to the positions shown in Fig. 1A.

In Fig. 6A the side panels shown comprise two side panels 31 and 32 at one side of the frame and door panels 33 and 34 at the opposite ends of the frame. It should be understood that two further side panels would normally be provided on the opposite side of the frame to the panels 31 and 32, but those are not shown in Fig. 6A. Top and/or bottom panels may also be provided.

The panels 31 and 32 have widths such that when placed side-by-side they can just be fitted between the frame members 4 and 6.

Fig. 6B shows the same parts as Fig. 6A, but in this case the frame members 3 to 6 are arranged in the configuration shown in Figs. 2A and 2B with the mounting angles 23 to 26 shown in the positions shown in Fig. 2A. In this configuration, the side panels 31 and 32 are disposed on opposite sides of and immediately adjacent to the upright frame members 4 and 6 which are immediately adjacent to one another.

Fig. 6C shows the same parts as Figs. 6A and 6B, but in this case the frame members 3 to 6 are arranged in the configuration shown in Figs. 3A and 3B with the mounting angles 23 to 26 shown in the positions shown in Fig. 3A, but with the enclosure frame viewed from the opposite side to Fig. 3A. In this configuration, the side panel 31 is disposed between the upright frame members 3 and 5 and the side panel 32 is disposed immediately to the rear of the frame member 5.

It will be understood that the arrangements of panels shown in Figs. 6A to 6C are merely examples of arrangements that can be adopted. In the case of all the examples of Figs. 6A to 6C it would often be desirable to supply two further side panels opposite the panels 31 and 32, and top and bottom panels might also be provided. In the case of an offset arrangement of the kind shown in Figs. 4A and 4B, however, the arrangement of side panels on the opposite sides of the frame would differ in accordance with the different arrangements of the upright frame members.

A situation where panels might be provided on only one side of an enclosure frame is when two or more frames are connected together side-by-side. It may then be advantageous to omit some or all of the side panels at the interface of adjacent frames. When frames are to be connected together side-by-side, the offset arrangement of frame members shown in Figs. 4A and 4B can be of particular advantage in allowing for one frame arrangement at an exterior side of the interconnected frames and a different frame arrangement at the one or more interior interfaces of the frames.

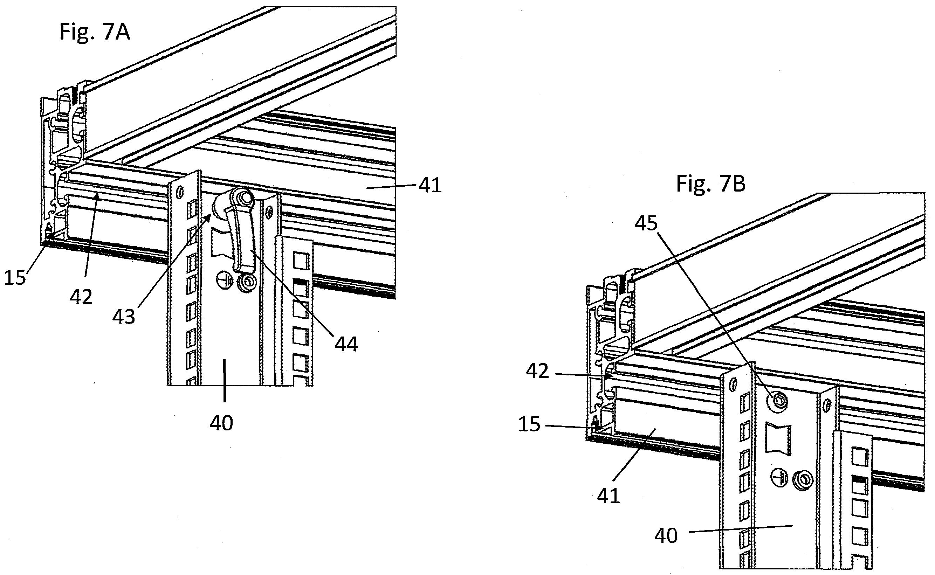

Referring now to Fig. 7A, there is illustrated one particular way of fixing the top of a mounting rail 40 to a side frame member 41. The mounting rail 40 in Fig. 7A might for example be the mounting rail 23 of Figs. 1A to 5B and the side frame member 41 in Fig. 7A might for example be the horizontal side frame member 7 in Figs. 1A to 5B. As can be seen in Fig. 7A, the side frame member 41 defines a longitudinal channel 42 in which a square or rectangular bolt head (not visible) of a fastener system can be mounted. The fastener system 43 comprises a bolt having the square or rectangular bolt head referred to immediately above and a shaft which extends inwardly from the bolt head through a hole in the top of the mounting rail 40 and has a screw threaded end portion which is engaged by an internally threaded handle 44. As will be understood, turning the handle 44 in one direction clamps the mounting rail 40 to the side frame member 41, whilst turning the handle 44 in the opposite direction releases the clamp and allows the position of the mounting rail 40 relative to the side frame member 41 to be altered by sliding the square or rectangular bolt of the fastener system 43 along the channel 42.

Fig. 7B shows a modified version of the arrangement shown in Fig. 7A and corresponding parts are shown by the same reference numerals. In the version of Fig. 7B, the handle 44 is replaced by a threaded fastener 45 which can be turned by a hex key engaging a hexagonal socket in the fastener.

Also visible in Figs. 7A and 7B is the channel 15 in which the upright frame members 3 and 5 are received.

Where in the foregoing description, integers or elements are mentioned which have known, obvious or foreseeable equivalents, then such equivalents are herein incorporated as if individually set forth. Reference should be made to the claims for determining the true scope of the present invention, which should be construed so as to encompass any such equivalents. It will also be appreciated by the reader that integers or features of the invention that are described as preferable, advantageous, convenient or the like are optional and do not limit the scope of the independent claims.

## Claims

1. An enclosure suitable for use in a telecommunications or data communications network, the enclosure being of generally cuboidal shape, including an upper frame assembly (1) that extends across an upper region of the enclosure, a lower frame assembly (2) that extends across a lower region of the enclosure, first, second, third and fourth upright frame members (3,4,5,6) connectible between the upper frame assembly and the lower frame assembly, and upright mounting angles (23,24,25,26) suitable for mounting equipment for use in a telecommunications or data communications network, the positions of the upright mounting angles (23,24,25,26) being able to be moved independently of the upright frame members (3,4,5,6), the enclosure being able to be assembled in a first configuration in which the first and second upright frame members (3,4) are disposed at the front of the enclosure at opposite sides thereof and the third and fourth upright frame members (5,6) are disposed at the rear of the enclosure at opposite sides thereof, **characterised in that** the first, second, third and fourth upright frame members (3,4,5,6) are connectible between the upper frame assembly (1) and the lower frame assembly (2) in a plurality of different positions in the regions of the sides of the enclosure to provide different configurations of the enclosure and the enclosure is also able to be assembled in a second configuration in which the first, second, third and fourth upright frame members (3,4,5,6) are disposed in regions spaced from the front and rear regions of the enclosure.

2. An enclosure according to claim 1, in which, in the second configuration of the enclosure, the first and third frame members (3,5) are adjacent to one another and the second and fourth frame members (4,6) are adjacent to one another.

3. An enclosure according to claim 1 or 2, in which, in the second configuration of the enclosure, there is an elongate vertical gap between the first and third frame members (3,5) and another elongate vertical gap between the second and fourth frame members (4,6).

4. An enclosure according to any preceding claim, in which, in the second configuration of the enclosure, the first, second, third and fourth frame members (3,4,5,6) are disposed approximately midway between the front and rear of the enclosure.

5. An enclosure according to any preceding claim, in which the enclosure is able to be assembled in a third configuration in which the first and second upright frame members (3,4) are disposed at the front of the enclosure and the third and fourth upright frame members (5,6) are disposed in a region spaced from the front and rear regions of the enclosure.

6. An enclosure according to any preceding claim, in which the enclosure is able to be assembled in a fourth configuration in which the third and fourth upright frame members (5,6) are disposed at the rear of the enclosure and the first and second upright frame members (3,4) are disposed in a region spaced from the front and rear regions of the enclosure.

7. An enclosure according to any preceding claim, in which the enclosure is able to be assembled in a fifth configuration in which the first and second upright frame members (3,4) are disposed at opposite sides of the enclosure and the third and fourth upright frame members (5,6) are disposed at opposite sides of the enclosure, with the first and third frame members (3,5) on one side of the enclosure and the second and fourth frame members (4,6) on the opposite side of the enclosure, and with the spacing of the first and third frame members (3,5) different from the spacing of the second and fourth frame members (4,6).

8. An enclosure according to claim 7, in which, in the fifth configuration, the first frame member (3) is disposed at the front of the enclosure, the third frame member (5) is disposed at the rear of the enclosure, and the second and fourth frame members (4,6) are disposed in regions spaced from the front and rear regions of the enclosure.

9. An enclosure according to any preceding claim, further including fifth and sixth upright frame members (20,21), and in which the enclosure is able to be assembled in the first configuration with the fifth and sixth upright frame members (20,21) disposed in regions spaced from the front and rear regions of the enclosure.

10. An enclosure according to any preceding claim, in which the upper and lower frame assemblies (1,2) include frame parts (7,8,11,12) extending substantially horizontally along the sides of the frame.

11. An enclosure according to claim 10, in which the upright frame members (3,4,5,6) are connectible to the frame parts (7,8,11,12) at a multiplicity of discrete positions along the frame parts.

12. An enclosure according to claim 10 or 11, in which the frame parts (7,8,11,12) have channels (15) extending along their lengths for receiving ends of the upright frame members.

13. An enclosure according to any preceding claim, further including one or more panels providing a cover for at least a part of a face of the enclosure.

14. An enclosure according to claim 13, in which the panels are mounted on the upper and lower frame assemblies.

15. A method of assembling an enclosure for use in a telecommunications or data communications network, the method including the steps of providing an enclosure according to any preceding claim, connecting the first, second, third and fourth upright frame members (3,4,5,6) in upright positions extending between the upper and lower frame assemblies (1,2) extending across the upper and lower regions of the enclosure respectively, wherein the positions at which the upright frame members (3,4,5,6) are connected to the upper and lower frame assemblies (1,2) is chosen to provide a selected one of a plurality of desired configurations of enclosure, the desired configurations including the first configuration in which the first and second upright frame members (3,4) are disposed at the front of the enclosure at opposite sides thereof and the third and fourth upright frame members (5,6) are disposed at the rear of the enclosure at opposite sides thereof, and the second configuration in which the first, second, third and fourth upright frame members (3,4,5,6) are disposed in regions spaced from the front and rear regions of the enclosure.

16. A method according to claim 15, further including the steps of assembling the enclosure in a chosen one of the plurality of configurations, subsequently dissembling the enclosure and reassembling the enclosure in another chosen one of the plurality of configurations.

## Patentansprüche

1. Gehäuse, das für die Verwendung in einem Telekommunikations- oder Datenkommunikationsnetzwerk geeignet ist, wobei das Gehäuse im Allgemeinen quaderförmig ist, einschließlich einer oberen Rahmenanordnung (1), die sich über einen oberen Bereich des Gehäuses erstreckt, einer unteren Rahmenanordnung (2), die sich über einen unteren Bereich des Gehäuses erstreckt, eines ersten, zweiten, dritten und vierten aufrechten Rahmenträgers (3, 4, 5, 6), die zwischen der oberen Rahmenanordnung und der unteren Rahmenanordnung verbindbar sind, und aufrechter Anbauwinkel (23, 24, 25, 26), die geeignet sind, um Ausrüstung zur Verwendung in einem Telekommunikations- oder Datenkommunikationsnetzwerk anzubringen, wobei die Positionen der aufrechten Anbauwinkel (23, 24, 25, 26) unabhängig von den aufrechten Rahmenträgern (3, 4, 5, 6) bewegt werden können, wobei das Gehäuse in einer ersten Konfiguration zusammengebaut werden kann, bei der der erste und der zweite aufrechte Rahmenträger (3, 4) an der Vorderseite des Gehäuses an gegenüberliegenden Seiten davon angeordnet werden und der dritte und der vierte aufrechte Rahmenträger (5, 6) an der Hinterseite des Gehäuses an gegenüberliegenden Seiten davon angeordnet sind, **dadurch gekennzeichnet, dass** der erste, zweite, dritte und vierte aufrechte Rahmenträger (3, 4, 5, 6) zwischen der oberen Rahmenanordnung (1) und der unteren Rahmenanordnung (2) in einer Vielzahl verschiedener Positionen in den Bereichen der Seiten des Gehäuses verbindbar sind, um verschiedene Konfigurationen des Gehäuses bereitzustellen, und wobei das Gehäuse auch in einer zweiten Konfiguration zusammengebaut werden kann, bei der der erste, zweite, dritte und vierte aufrechte Rahmenträger (3, 4, 5, 6) in Bereichen angeordnet sind, die von den vorderen und hinteren Bereichen des Gehäuses beabstandet sind.

2. Gehäuse nach Anspruch 1, wobei in der zweiten Konfiguration des Gehäuses der erste und dritte Rahmenträger (3, 5) aneinandergrenzen und der zweite und vierte Rahmenträger (4, 6) aneinandergrenzen.

3. Gehäuse nach Anspruch 1 oder 2, wobei in der zweiten Konfiguration des Gehäuses eine längliche vertikale Lücke zwischen dem ersten und dritten Rahmenträger (3, 5) und eine weitere längliche vertikale Lücke zwischen dem zweiten und vierten Rahmenträger (4, 6) vorliegen.

4. Gehäuse nach einem der vorstehenden Ansprüche, wobei in der zweiten Konfiguration des Gehäuses der erste, zweite, dritte und vierte Rahmenträger (3, 4, 5, 6) ungefähr mittig zwischen der Vorderseite und der Hinterseite des Gehäuses angeordnet sind.

5. Gehäuse nach einem der vorstehenden Ansprüche, wobei das Gehäuse in einer dritten Konfiguration zusammengebaut werden kann, bei der der erste und zweite aufrechte Rahmenträger (3, 4) an der Vorderseite des Gehäuses angeordnet sind und der dritte und vierte aufrechte Rahmenträger (5, 6) in einem Bereich angeordnet sind, der von dem vorderen und von dem hinteren Bereich des Gehäuses beabstandet ist.

6. Gehäuse nach einem der vorstehenden Ansprüche, wobei das Gehäuse in einer vierten Konfiguration zusammengebaut werden kann, bei der der dritte und vierte aufrechte Rahmenträger (5, 6) an der Hinterseite des Gehäuses angeordnet sind und der erste und zweite aufrechte Rahmenträger (3, 4) in einem Bereich angeordnet sind, der von dem vorderen und von dem hinteren Bereich des Gehäuses beabstandet ist.

7. Gehäuse nach einem der vorstehenden Ansprüche, wobei das Gehäuse in einer fünften Konfiguration zusammengebaut werden kann, bei der der erste und zweite aufrechte Rahmenträger (3, 4) an gegenüberliegenden Seiten des Gehäuses angeordnet sind und der dritte und vierte aufrechte Rahmenträger (5, 6) an gegenüberliegenden Seiten des Gehäuses angeordnet sind, wobei der erste und dritte Rahmenträger (3, 5) an einer Seite des Gehäuses und der zweite und vierte Rahmenträger (4, 6) an der gegenüberliegenden Seite des Gehäuses angeordnet sind und wobei der Abstand zwischen dem ersten und dritten Rahmenträger (3, 5) sich von dem Abstand zwischen dem zweiten und vierten Rahmenträger (4, 6) unterscheidet.

8. Gehäuse nach Anspruch 7, wobei in der fünften Konfiguration der erste Rahmenträger (3) an der Vorderseite des Gehäuses angeordnet ist, der dritte Rahmenträger (5) an der Hinterseite des Gehäuses angeordnet ist und der zweite und vierte Rahmenträger (4, 6) in Bereichen angeordnet sind, die von dem vorderen und von dem hinteren Bereich des Gehäuses beabstandet sind.

9. Gehäuse nach einem der vorstehenden Ansprüche, weiter umfassend einen fünften und einen sechsten aufrechten Rahmenträger (20, 21), und wobei das Gehäuse in der ersten Konfiguration zusammengebaut werden kann, wobei der fünfte und sechste aufrechte Rahmenträger (20, 21) in Bereichen angeordnet sind, die von dem vorderen und von dem hinteren Bereich des Gehäuses beabstandet sind.

10. Gehäuse nach einem der vorstehenden Ansprüche, wobei die obere und die untere Rahmenanordnung (1, 2) Rahmenteile (7, 8, 11, 12) umfassen, die im Wesentlichen horizontal entlang der Seiten des Rahmens verlaufen.

11. Gehäuse nach Anspruch 10, wobei die aufrechten Rahmenträger (3, 4, 5, 6) mit den Rahmenteilen (7, 8, 11, 12) an einer Vielzahl von einzelnen Stellen entlang der Rahmenteile verbunden werden können.

12. Gehäuse nach Anspruch 10 oder 11, wobei die Rahmenteile (7, 8, 11, 12) Kanäle (15) aufweisen, die entlang ihrer Längen verlaufen, um die Enden der aufrechten Rahmenträger aufzunehmen.

13. Gehäuse nach einem der vorstehenden Ansprüche, weiter umfassend eine oder mehrere Platten, die eine Abdeckung für mindestens einen Teil einer Fläche des Gehäuses bietet/bieten.

14. Gehäuse nach Anspruch 13, wobei die Platten an der oberen und an der unteren Rahmenanordnung befestigt sind.

15. Verfahren zum Zusammenbauen eines Gehäuses für die Verwendung in einem Telekommunikations- oder Datenkommunikationsnetzwerk, wobei das Verfahren die Schritte des Bereitstellens eines Gehäuses nach einem der vorstehenden Ansprüche umfasst, sowie das Verbinden des ersten, zweiten, dritten und vierten aufrechten Rahmenträgers (3, 4, 5, 6) in aufrechten Positionen, die zwischen der oberen und der unteren Rahmenanordnung (1, 2) verlaufen, die sich jeweils über den oberen und über den unteren Bereich des Gehäuses erstrecken, wobei die Positionen, an denen die aufrechten Rahmenträger (3, 4, 5, 6) mit der oberen und mit der unteren Rahmenanordnung (1, 2) verbunden sind, so ausgewählt sind, dass sie eine Konfiguration bereitstellen, die aus einer Vielzahl gewünschter Konfigurationen des Gehäuses ausgewählt wurde, wobei die erwünschten Konfigurationen die erste Konfiguration, bei der der erste und der zweite aufrechte Rahmenträger (3, 4) an der Vorderseite des Gehäuses an gegenüberliegenden Seiten davon angeordnet sind und der dritte und vierte aufrechte Rahmenträger (5, 6) an der Hinterseite des Gehäuses an gegenüberliegenden Seiten davon angeordnet sind, und die zweite Konfiguration, bei der der erste, zweite, dritte und vierte aufrechte Rahmenträger (3, 4, 5, 6) in Bereichen angeordnet sind, die von dem vorderen und von dem hinteren Bereich des Gehäuses beabstandet sind, umfassen.

16. Verfahren nach Anspruch 15, weiter umfassend die Schritte des Zusammenbauens des Gehäuses in einer Konfiguration, die aus einer Vielzahl von Konfigurationen ausgewählt wurde, des anschließenden Zerlegens des Gehäuses und des erneuten Zusammenbauens des Gehäuses in einer anderen Konfiguration, die aus der Vielzahl von Konfigurationen ausgewählt wurde.

## Revendications

1. Armoire appropriée à une utilisation dans un réseau de télécommunications ou de communications de données, l'armoire présentant en général une forme parallélépipédique, et comprenant un ensemble bâti supérieur (1) qui s'étend dans une région supérieure de l'armoire, un ensemble bâti inférieur (2) qui s'étend dans une région inférieure de l'armoire, des premier, deuxième, troisième et quatrième éléments de bâti droits (3, 4, 5, 6) qui peuvent être connectés entre l'ensemble bâti supérieur et l'ensemble bâti inférieur, et des cornières droites (23, 24, 25, 26) appropriées au montage d'un équipement destiné à être utilisé dans un réseau de télécommunications ou de communications de données, les positions des cornières droites (23, 24, 25, 26) pouvant être déplacées indépendamment des éléments de bâti droits (3, 4, 5, 6), l'armoire pouvant être assemblée selon une première configuration dans laquelle les premier et deuxième éléments de bâti droits (3, 4) sont disposés à l'avant de l'armoire sur des côtés opposés de celle-ci, et les troisième et quatrième éléments de bâti droits (5, 6) sont disposés à l'arrière de l'armoire sur des côtés opposés de celle-ci, **caractérisée en ce que** les premier, deuxième, troisième et quatrième éléments de bâti droits (3, 4, 5, 6) peuvent être connectés entre l'ensemble bâti supérieur (1) et l'ensemble bâti inférieur (2) en une pluralité de positions différentes dans les régions des côtés de l'armoire de façon à offrir des configurations différentes de l'armoire, et l'armoire peut être également assemblée selon une deuxième configuration dans laquelle les premier, deuxième, troisième et quatrième éléments de bâti droits (3, 4, 5, 6) sont disposés dans des régions éloignées des régions avant et arrière de l'armoire.

2. Armoire selon la revendication 1, dans laquelle, dans la deuxième configuration de l'armoire, les premier et troisième éléments de bâti (3, 5) sont adjacents l'un à l'autre, et les deuxième et quatrième éléments de bâti (4, 6) sont adjacents l'un à l'autre.

3. Armoire selon la revendication 1 ou la revendication 2, dans laquelle, dans la deuxième configuration de l'armoire, il existe un espace vertical allongé entre les premier et troisième éléments de bâti (3, 5), et un espace vertical allongé différent entre les deuxième et quatrième éléments de bâti (4, 6).

4. Armoire selon l'une quelconque des revendications précédentes, dans laquelle, dans la deuxième configuration de l'armoire, les premier, deuxième, troisième et quatrième éléments de bâti (3, 4, 5, 6) sont disposés approximativement à mi-chemin entre l'avant et arrière de l'armoire.

5. Armoire selon l'une quelconque des revendications précédentes, dans laquelle l'armoire peut être assemblée selon une troisième configuration dans laquelle les premier et deuxième éléments de bâti droits (3, 4) sont disposées à l'avant de l'armoire, et les troisième et quatrième éléments de bâti droits (5, 6) sont disposés dans une région éloignée des régions avant et arrière de l'armoire.

6. Armoire selon l'une quelconque des revendications précédentes, dans laquelle l'armoire peut être assemblée selon une quatrième configuration dans laquelle les troisième et quatrième éléments de bâti droits (5, 6) sont disposés à l'arrière de l'armoire, et les premier et deuxième éléments de bâti droits (3, 4) sont disposés dans une région éloignée des régions avant et arrière de l'armoire.

7. Armoire selon l'une quelconque des revendications précédentes, dans laquelle l'armoire peut être assemblée selon une cinquième configuration dans laquelle les premier et deuxième éléments de bâti droits (3, 4) sont disposés sur des côtés opposés de l'armoire, et les troisième et quatrième éléments de bâti droits (5, 6) sont disposés sur des côtés opposés de l'armoire, les premier et troisième éléments de bâti (3, 5) se situant sur un côté de l'armoire, et les deuxième et quatrième éléments de bâti (4, 6) se situant sur le côté opposé de l'armoire, l'espacement entre les premier et troisième éléments de bâti (3, 5) étant différent de l'espacement entre les deuxième et quatrième éléments de bâti (4, 6).

8. Armoire selon la revendication 7, dans laquelle, dans la cinquième configuration, le premier élément de bâti (3) est disposé à l'avant de l'armoire, le troisième élément de bâti (5) est disposé à l'arrière de l'armoire, et les deuxième et quatrième éléments de bâti (4, 6) sont disposés dans des régions éloignées des régions avant et arrière de l'armoire.

9. Armoire selon l'une quelconque des revendications précédentes, comprenant en outre des cinquième et sixième éléments de bâti droits (20, 21), et dans laquelle l'armoire peut être assemblée selon la première configuration, les cinquième et sixième éléments de bâti droits (20, 21) étant disposés dans des régions éloignées des régions avant et arrière de l'armoire.

10. Armoire selon l'une quelconque des revendications précédentes, dans laquelle les ensembles bâtis supérieur et inférieur (1, 2) comprennent des parties de bâti (7, 8, 11, 12) qui s'étendent de manière sensiblement horizontale le long des côtés du bâti.

11. Armoire selon la revendication 10, dans laquelle les éléments de bâti droits (3, 4, 5, 6) peuvent être connectés aux parties de bâti (7, 8, 11, 12) au niveau d'une multiplicité de positions discrètes le long des parties de bâti.

12. Armoire selon la revendication 10 ou la revendication 11, dans laquelle les parties de bâti (7, 8, 11, 12) présentent des canaux (15) qui s'étendent sur leurs longueurs et qui sont destinés à recevoir les extrémités des éléments de bâti droits.

13. Armoire selon l'une quelconque des revendications précédentes, comprenant en outre un ou plusieurs panneaux qui fournissent un capot à une partie au moins d'une face de l'armoire.

14. Armoire selon la revendication 13, dans laquelle les panneaux sont montés sur les ensembles bâtis supérieur et inférieur.

15. Procédé destiné à assembler une armoire appropriée à une utilisation dans un réseau de télécommunications ou de communications de données, le procédé comprenant les étapes consistant à fournir une armoire selon l'une quelconque des revendications précédentes, connecter les premier, deuxième, troisième et quatrième éléments de bâti droits (3, 4, 5, 6) dans des positions droites qui s'étendent entre les ensembles bâtis supérieur et inférieur (1, 2) qui s'étendent respectivement dans les régions supérieure et inférieure de l'armoire, dans lequel les positions où les éléments de bâti droits (3, 4, 5, 6) sont connectés aux ensembles bâtis supérieur et inférieur (1, 2), sont sélectionnées de façon à offrir l'une d'une pluralité de configurations souhaitées de l'armoire, les configurations souhaitées comprenant la première configuration dans laquelle les premier et deuxième éléments de bâti droits (3, 4) sont disposés à l'avant de l'armoire sur des côtés opposés de celle-ci, et les troisième et quatrième éléments de bâti droits (5, 6) sont disposés à l'arrière de l'armoire sur des côtés opposés de celle-ci, et la deuxième configuration dans laquelle les premier, deuxième, troisième et quatrième éléments de bâti droits (3, 4, 5, 6) sont disposés dans des régions éloignées des régions avant et arrière de l'armoire.

16. Procédé selon la revendication 15, comprenant en outre les étapes consistant à assembler l'armoire selon l'une sélectionnée de la pluralité de configurations, désassembler l'armoire par la suite, et réassembler l'armoire selon une autre sélectionnée de la pluralité de configurations.
